# EUROPÄISCHE PATENTANMELDUNG

(11) **EP 2 144 281 A1**
(43) Veröffentlichungstag der Anmeldung: **13.01.2010**
(21) Anmeldenummer: 08012395.3
(22) Anmeldetag: 09.07.2008
(51) Int. Cl.: H01L 21/329

(54) **Verfahren zum Erzeugen eines Substratkontakts in einem CMOS-Prozess**

(71) Anmelder: Micronas GmbH, 79108 Freiburg i. Br. (DE)
(72) Erfinder: Vecchi, Maria Cristina, Dr., 79104 Freiburg (DE); Werno, Jochen, Dr., 79194 Heuweiler (DE)
(74) Vertreter: Huwer, Andreas

(57) **Zusammenfassung**

Bei einem Verfahren zum Erzeugen eines Substratkontakfis (1) in einem CMOS-Prozess wird ein hoch dotiertes Halbleitersubstrat (2) eines Ladungströgertyps bereitgestellt, auf das eine niedriger dotierte Epitaxieschicht (3) des selben Ladungsträgertyps derart aufgebracht wird, dass sie an das Halbleitersubstrat (2) angrenzt. Zur Bildung des Substrat-Kontakts (1) werden in mindestens einen vom Halbleitersubstrat (2) beabstandeten oberflächennahen Bereich (4) der Epitaxieschicht (3) Dotierungselemente des Ladungsträgertyps implantiert. Es wird mindestens eine Wärmebehandlung durchgeführt, bei sich die Tiefe (7) des die Dotierungselemente aufweisenden Bereichs (4) um mindestens 50% vergrößert.

## Beschreibung

Die Erfindung betrifft ein Verfahren zum Erzeugen eines Substratkontakts in einem CMOS-Prozess, wobei ein hoch dotiertes Halbleitersubstrat eines Ladungsträgertyps bereitgestellt wird, auf das eine niedriger dotierte Epitaxieschicht des selben Ladungsträgertyps aufgebracht wird. Unter einem Substratkontakt wird ein elektrischer Kontakt verstanden, der sich von der Oberfläche der Epitaxieschicht in Richtung auf das Halbleitersubstrat zu erstreckt und eine elektrisch gut leitende Verbindung zum Halbleitersubstrat aufweist. Der Substratkontakt muss nicht notwendigerweise direkt mit dem Halbleitersubstrat in Kontakt stehen sondern kann auch etwas von diesem beabstandet sein.

Ein Verfahren der eingangs genannten Art ist aus der Praxis bekannt. Dabei wird zunächst ein Halbleitersubstrat eines vorbestimmten Ladungsträgertyps bereitgestellt. Auf dem Halbleitersubstrat wird zur Bildung eines "Buried Layers" eine Schicht des gleichen Ladungsträgertyps erzeugt. Danach wird auf diese Schicht und das Halbleitersubstrat eine Epitaxieschicht wiederum des gleichen Ladungsträgertyps aufgebracht. Dann wird ein Bereich der Epitaxieschicht, in dem später der Substrat-kontakt angeordnet sein soll, mit Hilfe eines Hochenergie- oder Megavolt-Implanters derart mit Dotierungselementen des genannten Ladungsträgertyps beschossen, dass die Dotierungselemente bis zu dem Buried Layer in die Epitaxieschicht vordringen. Die mit den Dotierungselementen dotierte Zone erstreckt sich dabei etwa orthogonal zur Substratebene, wobei ihr Querschnitt, ausgehend von der Oberfläche des Substrats zum Buried Layer hin etwa konstant ist. Der durch die dotierte Zone gebildete Substratkontakt benötigt daher nur wenig Substrat- bzw. Chipfläche. Das Verfahren hat jedoch den Nachteil, dass für die Herstellung des Substratkontakts ein relativ teurer Hochenergie-Implanter benötigt wird. Dieser ist jedoch in einem Standard-CMOS-Prozess häufig nicht verfügbar. Auch das Erzeugen des Buried Layers ist mit einem gewissen Aufwand verbunden.

Es besteht deshalb die Aufgabe, ein Verfahren der Eingang genannten Art zu schaffen, mittels dem ein niederohmiger Substratkontakt in einem CMOS-Prozess kostengünstig herstellbar ist.

Diese Aufgabe wird dadurch gelöst, dass ein hoch dotiertes Halbleitersubstrat eines Ladungsträgertyps bereitgestellt wird, auf das eine niedriger dotierte Epitaxieschicht eines gleichen Ladungsträgertyps derart aufgebracht wird, dass sie an das Halbleitersubstrat angrenzt, wobei zur Bildung des Substrat-Kontakts in mindestens einen vom Halbleitersubstrat beabstandeten oberflächennahen Bereich der Epitaxieschicht Dotierungselemente des Ladungsträgertyps implantiert werden, und dass mindestens eine Wärmebehandlung durchgeführt wird, bei sich die Tiefe des die Dotierungselemente aufweisenden Bereichs um mindestens 50% vergrößert.

Es wird also in einem CMOS-Prozess, bei dem die an der Oberfläche der Epitaxieschicht erzeugten Strukturen normalerweise derart ausgestaltet werden, dass sie eine möglichst geringe Substrat- oder Chip-Fläche überdecken, ein Substratkontakt durch eine Wärmebehandlung bis tief in die Epitaxieschicht eindiffundiert. Dabei wird die bei der Wärmebehandlung auftretende Verbreiterung des die Dotierungselemente aufweisenden Bereichs der Epitaxieschicht bewusst in Kauf genommen, um eine gut leitende elektrische Verbindung zwischen dem die Dotierungselemente aufweisenden Bereich und dem Halbleitersubstrat zu erreichen. Somit kann der Substratkontakt ohne die Verwendung eines teueren Hochenergie-Implanters auf einfache Weise in einem Standard CMOS-Prozess erzeugt werden.

Bei einer vorteilhaften Ausgestaltung der Erfindung wird die Wärmebehandlung derart durchgeführt, dass sich die Tiefe des die Dotierungselemente aufweisenden Bereichs um mindestens 100%, besser um mindestens 150% und bevorzugt um mindestens 200% vergrößert. Der Substratkontakt weist dann zwischen seiner Oberfläche und dem Halbleitersubstrat einen noch geringeren elektrischen Widerstand auf

Bei einer bevorzugten Ausgestaltung der Erfindung werden in die Oberfläche der Epitaxieschicht zur Bildung mindestens eines pn-Übergangs mit Dotierungen versehene Wannen eindiffundiert, wobei die Dosis und die Energie der Dotierungen, die Dosis und die Energie der in die Epitaxieschicht implantierten Dotierungselemente derart gewählt werden, dass nach Beendigung der Wärmebehandlung der die Dotierungselemente aufweisende Bereich der Epitaxieschicht näher am Halbleitersubstrat angeordnet ist als die Wannen. Während der Wärmebehandlung der für den Substratkontakt vorgesehenen Bereiche können also auch die für eine Halbleiterschaltung üblicherweise benötigten Wannen in die Epitaxieschicht eindiffundiert werden. Das Verfahren kann dadurch noch kostengünstiger in einem CMOS-Prozess angewendet werden.

Vorteilhaft ist, wenn die Tiefe des die Dotierungselemente aufweisenden Bereichs nach der Wärmebehandlung mindestens 50%, ggf mindestens 70%, insbesondere mindestens 80% und bevorzugt mindestens 90% der Dicke der Epitaxieschicht beträgt. Dabei verbreitert sich der die Dotierungselemente aufweisende Bereich ausgehend von der tiefsten Stelle zur Oberfläche der Epitaxieschicht hin. Gegebenenfalls ist es sogar möglich, dass der zweite Bereich an das Halbleitersubstrat angrenzt und/oder sich bis in dieses erstreckt.

Die Dotierungselemente werden bevorzugt in die Epitaxieschicht eingebracht, bevor die Dotierungen der Wannen in die Epitaxieschicht eindiffundiert werden. Die Dotierungselemente werden also zu Beginn des CMOS-Prozesses in die Epitaxieschicht implantiert, so dass die Dotierungselemente an allen in dem CMOS-Prozesses auftretenden Wärmebehandlungen teilnehmen.

Zweckmäßigerweise wird die Epitaxieschicht zur Bildung einer Feldoxidschicht während der Wärmebehandlung an ihrer Oberfläche oxidiert. Auch dadurch kann das erfindungsgemäße Verfahren noch kostengünstiger in einem CMOS-Prozess integriert werden.

Bei einer vorteilhaften Ausführungsform der Erfindung wird in der Epitaxieschicht seitlich benachbart zu dem die Dotierungselemente aufweisenden Bereich ein weiter Bereich erzeugt, dessen Ladungsträgertyp sich von demjenigen der Epitaxieschicht unterscheidet, wobei zur Bildung einer Diode der die Dotierungselemente aufweisende Bereich mit einer ersten Metallisierung und der weitere Bereich mit einer zweiten Metallisierung verbunden werden. Die nach dem Verfahren hergestellte Diode weist dann in Sperrrichtung oberhalb ihrer Durchbruchsspannung einen niedrigen Innenwiderstand auf

Nachfolgend ist ein Ausführungsbeispiel anhand der Zeichnung näher erläutert Es zeigt:
- Fig. 1: einen Teillängsschnitt durch einen Halbleiterwafer,
- Fig. 2: einen Teillängsschnitt durch einen Halbleiterchip, in den eine Diode integriert ist, und

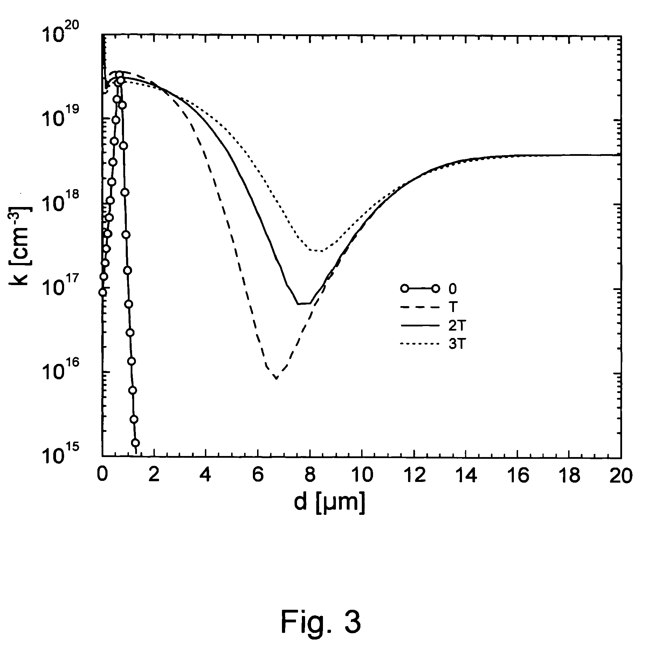

- Fig. 3: eine Graphische Darstellung der Konzentration von Dotierungselementen in dem Halbleiterwafer, wobei auf der Abszisse die Tiefe d und auf der Ordinate die Konzentration k aufgetragen sind und wobei T die Zeitdauer einer Wärmebehandlung für eine Standarddiffusion bedeutet.

Bei einem Verfahren zum Erzeugen eines Substratkontakts in einem Standard CMOS-Prozess wird ein hoch dotiertes Halbleitersubstrat 2 eines ersten Ladungsträgertyps bereitgestellt. Das Halbleitersubstrat 2 kann beispielsweise ein p-dotiertes oder n-dotiertes Silizium-Substrat sein.

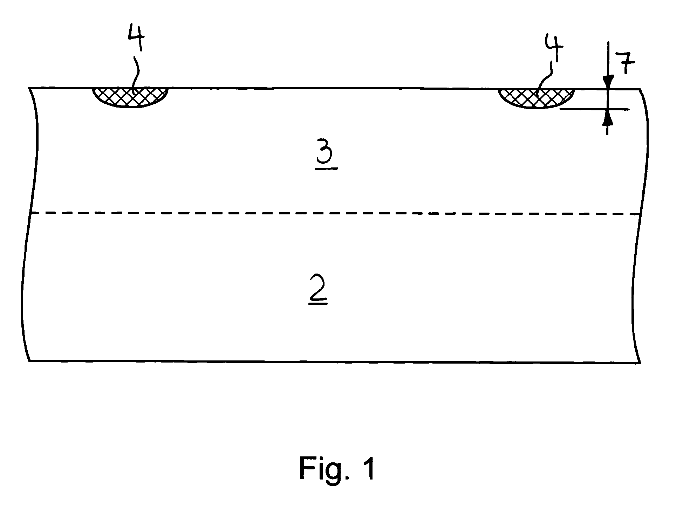

Auf das Halbleitersubstrat 2 wird eine niedriger dotierte Epitaxieschicht 3 des ersten Ladungsträgertyps aufgebracht. In Fig. 1 ist erkennbar, dass die Epitaxieschicht 3 direkt an das Halbleitersubstrat 2 angrenzt.

In voneinander beabstandete oberflächennahe Bereiche 4 der Epitaxieschicht 3 werden Dotierungselemente des ersten Ladungsträgertyps implantiert. Bei der Implantierung wird die Oberfläche der Epitaxieschicht 3 mit Hilfe eines Implanters derart mit den Dotierungselementen beschossen, dass diese in die Epitaxieschicht 3 eindringen. Die Dosis und die Energie der Dotierungselemente wird bei dem Beschuss so eingestellt, dass die Dotierungselemente in dem dotierten Bereich eine höhere Konzentration aufweisen als sämtliche Dotierungen, die in späteren Verfahrensschritten des CMOS-Prozesses in die Epitaxieschicht 3 eingebracht werden.

In die Oberfläche der Epitaxieschicht 3 werden zur Bildung eines pn-Übergangs für eine Diode mit Dotierungen versehene Wannen 5, 6 eindiffundiert. Eine erste Wanne 5 ist etwa mittig zwischen den Bereichen 4 angeordnet und im Wesentlichen kreisscheibenförmig ausgestaltet. Eine zweite Wanne 6 erstreckt entlang einer Kreislinie, die in der Oberfläche der Epitaxieschicht 3 angeordnet ist und die Wanne 5 umgrenzt.

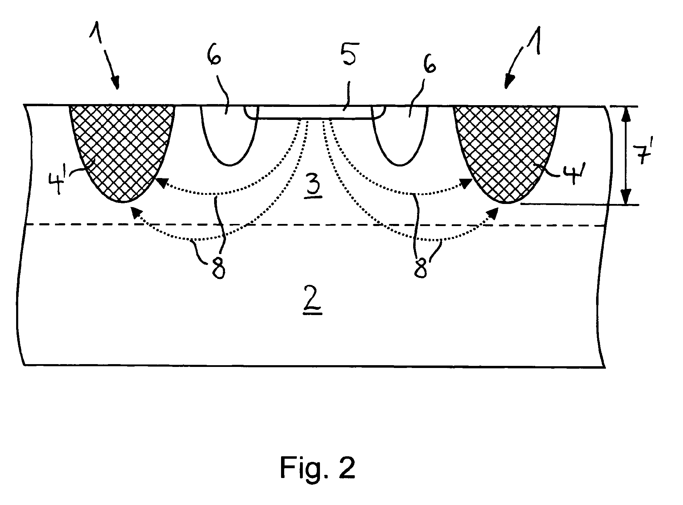

Zum Erzeugen der Wannen 5, 6 werden die Oberflächenbereiche der Epitaxieschicht 3, in denen die Wannen 5, 6 sein sollen, zunächst mit Hilfe des Implanters mit Dotierungselementen eines zweiten Ladungsträgertyps beschossen. Danach wird eine Wärmebehandlung durchgeführt, bei welcher die Dotierungselemente des ersten Ladungsträgertyps und die Dotierungselemente des zweiten Ladungsträgertyps in die Epitaxieschicht 3 diffundieren. Wie durch einen Vergleich von Fig. 1 mit Fig. 2 erkennbar ist, wird dabei jeder Bereich 4 sowohl in seitlicher Richtung als auch in Richtung auf das Halbleitersubstrat 2 zu in einen in Fig. 2 mit 4' bezeichneten Bereich vergrößert.

Die Temperatur und die Dauer der Wärmebehandlung werden so gewählt, dass der Bereich 4' mindestens die dreifache Tiefe aufweist wie der Bereich 4 vor der Wärmebehandlung. Dabei wird unter der Tiefe die größte Abmessung verstanden, die der Bereich 4 in einer orthogonal zur Erstreckungsebene des Halbleitersubstrats 2 verlaufenden Ebene aufweist. Unter dem Bereich 4 wird derjenige Bereich der Epitaxieschicht 3 verstanden, in dem die Konzentration der in die Epitaxieschicht 3 implantierten Dotierungselemente einen vorbestimmten Konzentrationswert überschreitet.

Die Tiefe bzw. Dicke des Bereichs 4 und die Konzentration der Dotierungselemente ist in Fig. 4 in Abhängigkeit von der Dauer der Wärmebehandlung graphisch dargestellt. Anhand der mit Kreisen markierten Linie ist erkennbar, dass der Bereich 4 vor der Wärmebehandlung nur eine relativ geringe Eindringtiefe in der Epitaxieschicht 3 aufweist. Diese beträgt etwa 1 µm. Durch eine Wärmebehandlung, deren Dauer der Dauer einer Standarddiffusion entspricht, kann die Eindringtiefe des Bereichs 4 etwa auf 6,5 µm vergrößert werden. Nach einer Wärmebehandlung, deren Dauer das Doppelte der Dauer einer Standarddiffusion entspricht, beträgt die Tiefe 7' des Bereichs 4 etwa 6,5 µm. Bei einer weiteren Erhöhung der Wärmebehandlungsdauer nimmt die Tiefe 7' des Bereichs 4 nur noch langsam zu.

Durch Diffusion der Dotierungselementen des zweiten Ladungsträgertyps vergrößern sich auch die Wannen 5, 6 jeweils in seitlicher Richtung als auch in Richtung auf das Halbleitersubstrat 2 zu. In Fig. 2 ist erkennbar, dass ein Außenrandbereich der ersten Wanne 5 nach der Wärmebehandlung seitlich in die zweite Wanne 6 eingreift.

Wie aus den in Fig. 2 punktiert angedeuteten Stromflusslinien ersichtlich ist, ermöglicht der Substrat-Kontakt über die Epitaxieschicht 3 eine elektrisch gut leitende Verbindung zwischen der als Kathode dienenden ersten Wanne 5 und dem als Anode dienenden Substratkontakt 1 der Diode.

## Patentansprüche

1. Verfahren zum Erzeugen eines Substratkontakts (1) in einem CMOS-Prozess, wobei ein hoch dotiertes Halbleitersubstrat (2) eines Ladungsträgertyps bereitgestellt wird, auf das eine niedriger dotierte Epitaxieschicht (3) des selben Ladungsträgertyps derart aufgebracht wird, dass sie an das Halbleitersubstrat (2) angrenzt, wobei zur Bildung des Substrat-Kontakts (1) in mindestens einen vom Halbleitersubstrat (2) beabstandeten oberflächennahen Bereich (4) der Epitaxieschicht (3) Dotierungselemente des Ladungsträgertyps implantiert werden, und wobei mindestens eine Wärmebehandlung durchgeführt wird, bei sich die Tiefe (7) des die Dotierungselemente aufweisenden Bereichs (4) um mindestens 50% vergrößert.

2. Verfahren nach Anspruch 1, **dadurch gekennzeichnet, dass** die Wärmebehandlung derart durchgeführt wird, dass sich die Tiefe (7) des die Dotierungselemente aufweisenden Bereichs (4) um mindestens 100%, besser um mindestens 150% und bevorzugt um mindestens 200% vergrößert.

3. Verfahren nach Anspruch 1 oder 2, **dadurch gekennzeichnet, dass** in die Oberfläche der Epitaxieschicht (3) zur Bildung mindestens eines pn-Übergangs mit Dotierungen versehene Wannen (5, 6) eindiffundiert werden, und dass die Dosis und die Energie der Dotierungen, die Dosis und die Energie der in die Epitaxieschicht (3) implantierten Dotierungselemente derart gewählt werden, dass nach Beendigung der Wärmebehandlung der die Dotierungselemente aufweisende Bereich (4') der Epitaxieschicht (3) näher am Halbleitersubstrat (2) angeordnet ist als die Wannen (5, 6).

4. Verfahren nach einem der Ansprüche 1 bis 3, **dadurch gekennzeichnet, dass** die Tiefe (7') des die Dotierungselemente aufweisenden Bereichs (4') nach der Wärmebehandlung mindestens 50%, ggf mindestens 70%, insbesondere mindestens 80% und bevorzugt mindestens 90% der Dicke der Epitaxieschicht (3) beträgt.

5. Verfahren nach einem der Ansprüche 1 bis 4, **dadurch gekennzeichnet, dass** die Dotierungselemente in die Epitaxieschicht (3) eingebracht werden bevor die Dotierungen der Wannen (5, 6) in die Epitaxieschicht (3) eindiffundiert werden.

6. Verfahren nach einem der Ansprüche 1 bis 5, **dadurch gekennzeichnet, dass** die Epitaxieschicht (3) zur Bildung einer Feldoxidschicht während der Wärmebehandlung an ihrer Oberfläche oxidiert wird.

7. Verfahren nach einem der Ansprüche 1 bis 6, **dadurch gekennzeichnet, dass** in der Epitaxieschicht (3) seitlich benachbart zu dem die Dotierungselemente aufweisenden Bereich (4, 4') ein weiter Bereich erzeugt wird, dessen Ladungsträgertyp sich von demjenigen der Epitaxieschicht (3) unterscheidet, und dass zur Bildung einer Diode der die Dotierungselemente aufweisende Bereich (4, 4') mit einer ersten Metallisierung und der weitere Bereich mit einer zweiten Metallisierung verbunden werden.
